(19)

Europäisches
Patentamt
European
Patent Office
Office européen
des brevets

(11) **EP 4 210 055 A1**

(12) **EUROPEAN PATENT APPLICATION**

(43) Date of publication:
**12.07.2023 Bulletin 2023/28**

(21) Application number: **22150589.4**

(22) Date of filing: **07.01.2022**

(51) International Patent Classification (IPC):
**G11C 7/10** (2006.01)        **G06F 7/523** (2006.01)
**G06F 7/53** (2006.01)        **G06N 3/063** (2023.01)

(52) Cooperative Patent Classification (CPC):
**G11C 7/1006; G06N 3/065**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **IHP GmbH - Innovations for High
Performance
Microelectronics / Leibniz-Institut für
innovative Mikroelektronik
15236 Frankfurt (Oder) (DE)**

(72) Inventors:
• **Kahmen, Gerhard
15236 Frankfurt (Oder) (DE)**
• **Krstic, Milos
15236 Frankfurt (Oder) (DE)**

(74) Representative: **Eisenführ Speiser
Patentanwälte Rechtsanwälte PartGmbB
Stralauer Platz 34
10243 Berlin (DE)**

(54) **CHARGE-REDISTRIBUTION BASED VECTOR MATRIX MULTIPLIER**

(57)     For performing in-memory multiplication of an input vector with an input matrix a storage component matrix comprises matrix memory components with a charge storage component that is tuneable by a respective matrix input signal to assume a capacitance value uniquely corresponding to an input matrix value. A vector input switch controls provision of the analog input vector signal for charging the charge storage component of the matrix memory component to a charge amount representing a mathematical product of the respective input vector value and the respective input matrix value. The matrix memory components of a column are arranged in parallel connection with each other and commonly connected in series connection with a column summation charge storage component which accumulates the charge amounts output from the charge storage components to generate a column summation output voltage indicative of a sum of the component products.

Fig. 1a

EP 4 210 055 A1

**Description**

The present invention is directed to a programmable in-memory computing device for performing multiplication of an input vector with an input matrix. It is also directed to a method for performing multiplication of an input vector an input matrix having input matrix.

Matrix operations play an important role in numerous technical applications such as image processing, signal processing, cryptography, and significantly increasingly in the field of artificial intelligence (AI). For example, matrix operations play a central role in artificial neural networks.

In mathematics, a matrix is an array or table of numbers or expressions arranged in rows and columns. Matrix operations involve multiplying individual factors and adding up (accumulating) whole column products to produce a result. Known solutions to implementing matrix operations in technical systems make use of an algorithmic approach using central processing units (CPUs), graphics processing units (GPUs), digital signal processors (DSPs). To reduce the required amount of clock cycles per matrix operation, another known approach makes use of dedicated digital hardware using field programmable arrays (FPGAs) or semi-custom application specific integrated circuit (ASIC) designs in digital form using digital multipliers and adders. Especially in applications designed for energy efficiency, e.g. edge computing systems, this approach may have limitations. Another disadvantage is a high amount of data transport between memory and the arithmetic unit.

For this reason, in-memory computing and analog signal processing approaches are becoming increasingly important. The advantages of such approaches are that the computational operation and the storage of the data take place locally at the same place and thus the amount of data transport is minimized. Furthermore, topologies or structures are chosen that inherently perform the desired operation and are therefore also very time efficient compared to classical approaches.

Resistive random access memory (RRAM) based approaches for the execution of matrix operations are currently a subject of intensive research, e.g. in the realization of neural networks. In RRAM, the operation of multiplying the vector elements with the matrix elements is based on Ohm's law $I = U/R$.

Current approaches to the monolithic integration of RRAM devices into standard chip fabrication technologies like CMOS or BiCMOS rely on back-end-of-line (BEOL) processes. A recent approach is described in Amirali Amirsoleimani et al, Adv. Intell. Syst. 2020, 2, 2000115. The physical implementation involves the application of an input vector as a voltage vector into word-lines of an array via bottom electrodes. A weight matrix is stored as the device conductance, and the output is sensed as accumulated current in the bit-line via top electrodes.

Technical challenges that are associated the RRAM approach include :

a) The accumulation is done by adding all single currents, resulting in currents of high total magnitude. High current magnitudes result in high power dissipation. Furthermore, the currents must flow continuously during the operations. Power dissipation increases with the time of current flow.

b) Since the currents must flow continuously, a separate V-DAC is required for each vector element.

c) RRAM devices show a wide dispersion so that inherently only a resolution of max. 3-4 bits is possible. Higher resolutions can be only be achieved with increased expenditure using switchable RRAM sub-matrices, which generate the desired resistance value by interconnecting individual MEM resistor elements and exploiting the statistical dispersion of the individual elements.

It is an object of the present invention to reduce or overcome these challenges.

According to a first aspect of the present invention, a programmable in-memory computing device for performing multiplication of an input vector of input vector values with an input matrix having input matrix columns of input matrix values is provided. The device has a storage component arrangement, hereinafter storage component matrix that comprises

- matrix memory components that are arranged and connected to represent matrix component rows and matrix component columns of the storage component matrix;

- a matrix input device for providing to the matrix memory components respective matrix input signals indicative of input matrix values of an input matrix;

- a vector input device for providing to the matrix memory components analog input vector signals in the form of respective voltage amounts uniquely corresponding to input vector values of the input vector.

Each matrix memory component of the storage component matrix comprises

- a tuneable charge storage component that is connected between the vector input device and a reference potential and that is tuneable by the respective matrix input signal to assume a capacitance value uniquely corresponding to the respective input matrix value; and

- a vector input switch for controlling provision of the respective analog input vector signal for charging the charge storage component of the matrix component to a charge amount representing a mathematical product of the respective input vector value and the respective input matrix value.

The matrix memory components of a given matrix component column are each followed by a component product accumulation switch for controlling an output of the charge amount from the respective matrix memory component, and are arranged in a parallel connection with each other and commonly connected in a series connection with a respective column summation charge storage component that is configured to accumulate the respective charge amounts output from the charge storage components so as to generate a column summation output voltage that is indicative of a sum of the component products.

With the programmable in-memory computing device of the present invention, the mathematical operation of vector-matrix multiplication is implemented in the form of a "natural processing" scheme using the fundamental physical laws governing the charging of capacitors.

The programmable in-memory computing device of the present invention combines several advantages. It can be implemented in a monolithic integrated circuit fabricated using in any CMOS or BiCMOS technology using the MOS devices that are available in these technologies, such as switches, but also MOS capacitors or (where available) standard MIM or interdigital capacitors as the charge storage components and without requiring additional technology modules. Especially since MOS capacitances can be fabricated in very small size and high area density the in-memory computing device can achieve a particularly good utilization of chip area.

Furthermore, in comparison with RRAM solutions, the in-memory computing device of the present invention is based on a completely different approach for implementation of the multiplication operation. RRAM is based on tuneable resistive elements and thus exploits the proportionality of an output voltage to an input current via the programmable ohmic resistance using Ohm's law. In contrast, the solution of the invention is based on the proportionality of an output charge to an input voltage via the capacitance of a tuneable capacitor. Only low charge amounts are required to charge a tuneable capacitor to represent the product of an input vector value and an input matrix value. This allows using particularly small capacitors requiring only small chip area. Furthermore, since no summation of current signals is required to determine the contributions of each column to the matrix product, a significantly lower power dissipation can be achieved with the in-memory computing device of the present invention in comparison with known RRAM technologies. As will become evident from the description of embodiments, the in-memory computing device of the present invention allows achieving a particularly high resolution of the determined product value, which is higher than that of known RRAM-based devices.

In the following, embodiments of the in-memory computing device will be described.

For determining the vector-matrix multiplication result, the accumulated charge of the column summation charge storage components is suitably determined via the voltage between the respective capacitor electrodes. To this end, the device suitably further comprises a column read device for determining a set of column summation output voltages of the column summation charge storage components and for providing a matrix product output signal indicative of the set of the column summation output voltages.

For enabling a next vector-matrix multiplication, further embodiments preferably comprise, for each matrix memory component column, a column reset switch, which is connected in parallel to its column summation charge storage component to discharge the summation charge storage component via its connection to the reference potential in its closed state.

In order to control the operation of the in-memory computing device, further advantageous embodiments comprise

- a matrix switch phase controller, which is configured to control the vector input switches, the component product accumulation switches, the component reset switches and the column reset switches of the computation matrix to operate the device in one of a respective number of switching phases at a given time, the switching phases comprising:

- a vector load phase, in which the vector input switches are switched to allow applying the input vector signals for charging the charge storage components;

- a summation phase after the vector load state, in which the component product accumulation switches are switched to allow transferring respective charge amounts from the charge storage components for accumulation in the summation charge storage component;

- a measurement phase after the summation phase, in which the charge of the summation charge storage component of each storage component column is measured; and a reset phase, in which the summation charge storage components of the matrix component columns are discharged.

To mitigate memory effects and intersymbol interferences, each matrix memory component of one embodiment comprises a respective component reset switch, which is connected in parallel to its charge storage component to discharge the charge storage component via its connection to the reference potential in its closed state. In this embodiment, the matrix switch phase controller is preferably configured to additionally control discharging of the charge storage components of the matrix memory component in the reset state.

Different alternative embodiments of the vector input device can be used to provide the input vector values to the matrix memory component. Some embodiments are based on providing an analog input. Other embodiments, which are currently preferred, are based on a digital input. The vector input device of these other embodiments is thus configured to provide to each matrix memory component a digital voltage signal indicative of the respective input vector value.

In one of these alternative embodiments, each matrix memory component has a digital-to-analog converter, hereinafter V-DAC, which is configured to receive the respective digital voltage signal and provide the respective input vector signal in the form of an analog voltage signal. Moreover, the matrix switch phase controller is configured to control switching states, i.e., an open or closed state, of the vector input switches of the individual matrix memory components in parallel. In this embodiment, the digital-to-analog conversion of the digital voltage signals is thus performed in the matrix memory components, suitably between the vector input device and the charge storage component of the given matrix memory component. This allows providing the respective digital voltage signals to the matrix memory components at the same time, i.e. in parallel.

In another one of these alternative embodiments, the vector input device comprises one V-DAC for each column of matrix memory components and is configured to provide to the V-DACs the input vector signals for the respective column as a time sequence. The matrix switch phase controller of this embodiment is configured to control switching states of the vector input switches of the individual matrix memory components in correspondence with the time sequence. In comparison with the previous alternative, this embodiment saves chip area by requiring less V-DACs.

Another group of embodiments provides different solutions for charging the charge storage component with a charge that represents the product of the input vector value and the input matrix value. The following embodiments can be combined to form further embodiments.

In a first embodiment of this group, the voltage amount of the input vector signal is set in accordance with the respective input vector value during a fixed time span of charging the charge storage component. The matrix switch phase controller of this embodiment is configured to control the vector input switch of each matrix memory component to allow the charging of the charge storage component of the respective matrix memory component for a common fixed amount of time. In this embodiment, the vector input device is configured to provide the vector input signal in the form of an analog voltage signal having a voltage amount uniquely corresponding to the respective input vector value.

In a second embodiment of this group, the time span of charging the charge storage component is set in accordance with the respective input vector value, which is provided using a fixed voltage amount. In this embodiment, the matrix switch phase controller is configured to control the vector input switch of each matrix memory component in the vector load state to allow the charging of the charge storage component of the matrix memory component for a an amount of time that uniquely corresponds to the input vector value. The vector input device is configured to provide the vector input signal in the form of an analog voltage signal having a fixed voltage amount.

In a third embodiment, a tuneable resistor provided in each matrix memory component is set to a resistance value in accordance with a given input vector value, while a time of charging and a voltage amount applied during the time of charging the tuneable charge storage component are kept constant. In this embodiment, each matrix memory component comprises between its vector input switch and its charge storage component a resistive element that is tuneable to assume a resistance value uniquely corresponding to a given input vector value. The matrix switch phase controller of this embodiment is configured to control the vector input switch of each matrix memory component in the vector load state to allow the charging of the charge storage component of the matrix memory component with the for a common fixed amount of time, and to tune the resistive element to assume a resistance value uniquely corresponding to the current input vector value. The vector input device is configured to provide the vector input signal in the form of an analog voltage signal having a fixed voltage amount. By varying the resistance of the resistive element, the charge amount that is transported to the charge storage component of the matrix memory component during a fixed amount of time and under a given applied voltage amount can be varied. This in turn determines the input vector value as one factor of the product of an input vector value and an input matrix value that is computed using the respective matrix memory component. As in all other embodiments, the input matrix value is determined by the tuneable capacitance of the charge storage component.

The tuneable charge storage component is implemented in different embodiments in different ways. In some embodiments, the tuneable charge storage component is a semiconductor component, and in particular implemented by a p-n junction or an MIS structure of the semiconductor component. In the first case, the semiconductor component is for instance a diode, a varactor or varicap diode, or a bipolar transistor. In the second case, the semiconductor component is for instance a MIS capacitor, such as the well-known gate layer/insulator layer/semiconductor layer structure of a MOS transistor or MOS varactor. All these semiconductor components can be fabricated using a known MOS technology such as a CMOS or BiCMOS technology. The thickness of a depletion layer of a reverse-biased pn junction or MOS layer structure varies with the DC voltage applied and provides for a tuneable capacitance.

In other embodiments, the tuneable charge storage component is a C-DAC which can be binary weighted having a plurality of capacitors arranged in parallel, each capacitor corresponding in capacitance value to a power of 2. In this embodiment, the matrix input signal is preferably implemented as a digital binary signal. The individual bit values of this matrix input signal control activation or deactivation of the capacitances of the tuneable charge storage component in correspondence with the respective input matrix value. Other types of C-DACs, in particular a C-DAC that is not binary weighted can be used as well, with corresponding adaptation of the matrix input signal. Alternatively, a CDAC can consist of several fixed capacitors (MIM or interdigital), which are switched via FET transmission gates.

A further aspect of the present invention is formed by a method for performing multiplication of an input vector of input vector values with an input matrix having input matrix columns of input matrix values. The method comprises:

- providing a programmable in-memory computing device according to the first aspect of the invention or one of its embodiments;

- providing to the device an input matrix having input matrix columns of input matrix values, and an input vector of input vector values;

- charging the charge storage components of the matrix memory component to respective charge amounts, each representing a mathematical product of a respective input vector value and a respective input matrix value;

- column-wise accumulating the respective charge amounts output from the charge storage components so as to generate column summation output voltages indicative of a respective sum of the component products in a given column of the matrix;

- determining a set of the column summation output voltages as the product of the input vector with the input matrix.

The method of the present aspect of the invention shares the advantages explained in the context of the programmable in-memory computing device of the invention.

Further embodiments will be explained in the following with reference to the enclosed drawings. In the drawings:

Figs. 1a and 1b show a simplified circuit diagram of an embodiment of a matrix memory component and a schematic block representation of this matrix memory component for use in a programmable in-memory computing device for performing multiplication of an input vector of input vector values with an input matrix having input matrix columns of input matrix values;

Figs. 2a and 2b show a simplified circuit diagram of another embodiment of a matrix memory component and a schematic block representation of this matrix memory component;

Fig. 3a is a simplified circuit diagram of a matrix column of an embodiment of a storage component matrix of a programmable in-memory computing device;

Fig. 3b is a timing diagram for vector input switches for controlling provision of the analog input vector signals for charging the respective charge storage components of the matrix column of Fig. 3a;

Fig. 4a is a simplified circuit diagram of a column of a further embodiment of a storage component matrix of a programmable in-memory computing device;

Fig. 4b is a timing diagram for vector input switches for controlling provision of the analog input vector signals for charging the respective charge storage components of the matrix column of Fig. 4a;

Before turning to the description of the drawings, a brief outline of vector-matrix multiplication is given. A simple example of a vector-matrix multiplication, hereinafter in short VMM, is given in the following by the multiplication of vector that has two vector values a and b with a 2×2 matrix that has four matrix values c, d, e and f.:

$$(a \quad b) \cdot \begin{pmatrix} c & d \\ e & f \end{pmatrix} = ((ac + be) \quad (ad + bf))$$

Generally, the values a to f can be any number or mathematical expression. In the context of the present specification, the values are represented by electrical signals, as will be described in more detail below. Furthermore, the present specification refers to the vector values as input vector values, and to the matrix values as input matrix values.

VMM is a frequently-used operation in computing, real-time signal processing, and machine learning. In-memory computing devices have been developed to accelerate computing operations such as VMM, in particular by avoiding a transport of data between the processor memory (cache) and a storage system, as required in implementations of the popular von Neumann computer architecture. For performing VMM or other operations, in-memory computing devices suitably have a matrix structure of matrix memory components. The matrix memory component forms the elementary building block or memory cell, which is replicated in desired numbers in an in-memory computing device. The individual matrix memory components are arranged and connected to represent matrix component rows and matrix component columns of the storage component matrix.

While in-memory computing can be performed in the digital or analog domain, the present specification is directed to an in-memory computing concept that works in the analog domain. The analog signal processing performed by the in-memory computing device disclosed in the present specification is advantageous in comparison with digital implementations in particular in terms of required chip area, speed (low number of required clock cycles) and power consumption. The computing operation performed by the individual matrix memory components is a multiplication of analog input signals that represent input vector values and input matrix values. Furthermore, an addition or accumulation of determined products is performed, in correspondence with the mathematical rule for performing VMM.

As described in the introductory part of this specification, resistive random access memory (RRAM) based approaches are known for the execution of such matrix operations. In contrast to those known approaches, the present invention employs a charge-redistribution approach. This approach involves an input-dependent charging of a tuneable capacitance for implementing the individual multiplication of an input vector value and an input matrix value in a given matrix memory component, and a subsequent accumulation of the charges from the different matrix memory components of a given matrix column in a respective column summation charge storage component.

The following description first turns to different embodiments of a matrix memory component that forms the elementary building block performing the individual multiplication operation.

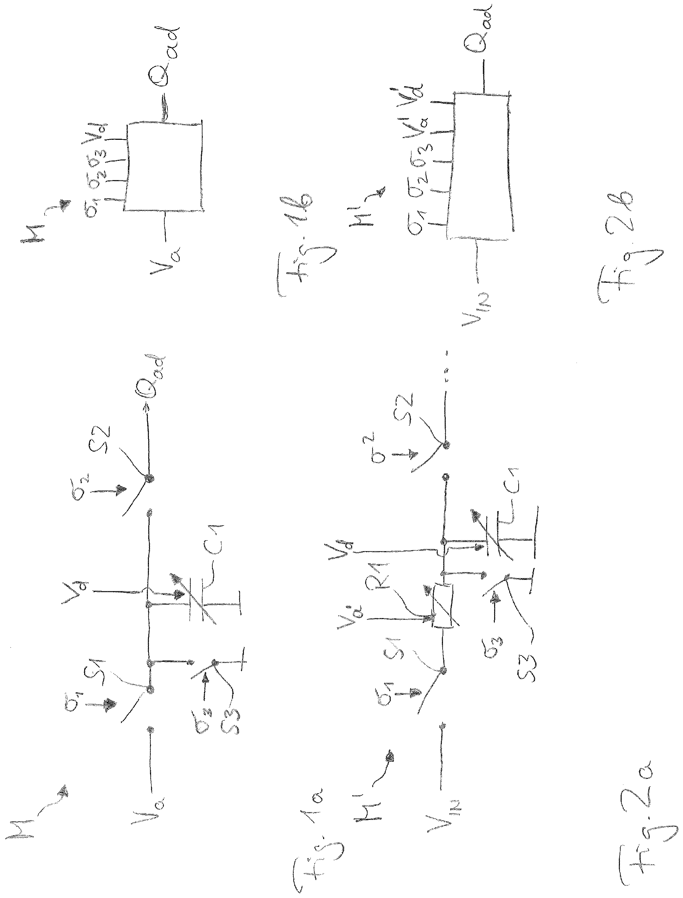

Figs. 1a shows a simplified circuit diagram of an embodiment of a matrix memory component M for use in a programmable in-memory computing device for performing multiplication of an input vector of input vector values with an input matrix having input matrix columns of input matrix values. Fig. 1b is a schematic block representation of this matrix memory component.

The matrix memory component M receives an analog voltage signal $V_a$ from a vector input device (not shown). This analog input vector signal uniquely corresponds to an input vector value a of an input vector. Without limitation and for the purpose of clarity only, the present description of Fig. 1a and 1b is based on the use of an input vector signal in the form of an analog electrical signal that has a voltage amount which corresponds to the input vector value a. Alternative implementations of the input vector signal will be discussed below.

The input vector signal $V_a$ is fed to a tuneable charge storage component C1 via a vector input switch S1. The tuneable charge storage component C1 is connected between a first potential corresponding to a input vector signal $V_a$ when the vector input switch is closed, and a reference potential such as a mass or ground potential or any other potential used as a reference. The vector input switch S1 is controlled by providing a switching signal $\sigma_1$ that assumes either a closed state or an open state. The closed state is used in the context of a vector load phase to allow applying the input vector signal for charging the charge storage component C1 with a charge amount $Q_{ad}$ that depends on the input vector signal $V_a$ and on an assumed capacitance value $C_d$ of the tuneable charge storage component C1, according to the formula:

$$Q_{ad} = C_d \cdot V_a$$

This is based on a suitably selected charging time, i.e. duration of the vector load phase. Thus, the charge $Q_{ad}$ stored on the tuneable charge storage component C1 is achieved to be uniquely correspondent with the product of the tuned capacitance value $C_d$ corresponding to a matrix input value d and of the amount of the input vector signal $V_a$ that

corresponds to the input vector value a. The matrix input value d to a control signal determining the capacitance value that is in unique correspondence with the matrix input value. Depending on the implementation of the tuneable charge storage component C1, the control signal can be provided in the form of single signal component or as a vector signal having a plurality signal components. This will be further elucidated in the context of exemplary implementations of the tuneable charge storage component C1 further below.

The matrix memory component M further has a component product accumulation switch S2 for blocking or allowing an output of the stored charge amount $Q_{ad}$ from the charge storage component to a summation charge storage component (not shown in Fig. 1a). The switching state of the component product accumulation switch S2 is controlled by an accumulation control signal $\sigma_2$. When the component product accumulation switch S2 is closed in a summation phase after the vector load phase, the charge amount $Q_{ad}$ stored on the tuneable charge storage component C1 can be output to the summation charge storage component. In contrast, when the component product accumulation switch S2 is open, no charge transfer from the tuneable charge storage component C1 towards the summation charge storage component is possible. In the summation phase, the vector input switches S1 of the individual matrix memory components are open to avoid any further charging of their charge storage components C1.

Furthermore, a storage component reset switch S3 is connected in parallel to the tuneable charge storage component C1. In the present embodiment, the storage component reset switch is connected on the input side of the tuneable capacitor forming the charge storage component C1 between the vector input switch S1 and C1. However, it may alternatively be arranged on the output side between C1 and the component product accumulation switch S2. The storage component reset switch is controlled using a storage component reset signal $\sigma_3$. When the storage component reset switch is closed, the charge storage component C1 of the matrix memory component M is discharged. This is particularly useful in a reset phase after the summation phase in order to avoid any memory effects. However, it is noted that the provision of the storage component reset switch S3 may be unnecessary, for instance if the used capacitor technology does not exhibit significant memory effects or a low-ohmic vector voltage source or a sufficient long charging time is used.

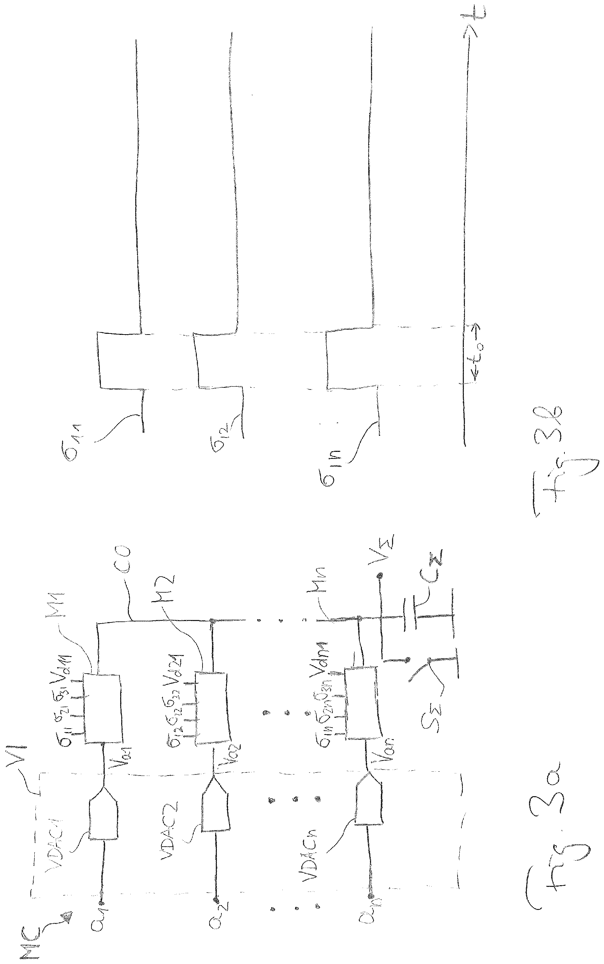

Details of the switching control for the vector input switch S1 will be described further below in the context of the description of Fig. 3, when going into more detail of the operation of an in-memory computing device according to the present invention.

The tuneable charge storage component C1 can be implemented in different forms. One implementation is a semiconductor component, such as a semiconductor diode or a transistor with a junction between p- and n-conductive semiconductor regions (pn junction).

The width of a depletion region formed at the pn junction can be controlled by application of a control voltage $V_d$ of suitable polarity, i.e., a reverse voltage and of suitable amount across the pn junction. This way, the capacitance associated with the pn junction is tuned. This control voltage is employed in accordance with the present invention as a matrix input signal $V_d$ that uniquely corresponds to an input matrix value of an input matrix. By varying the matrix input signal, the capacitance of the charge storage component is varied accordingly.

In embodiments that advantageously require particularly little chip area, FEOL capacitor structures are used for implementing the tuneable charge storage component C1. For example, diodes or MOS Caps that are available in known CMOS or BiCMOS FEOL technologies can be used to implement the tuneable charge storage component C1. Depending on a given technology and design environment, individual semiconductor components of this kind may have a capacitance that is too small for a desired application case. In such cases, a parallel connection of a suitable number of individual semiconductor components or pn-junctions can be used to achieve a desired capacitance value. The matrix input signal is then applied to all the pn-junctions or MOS Caps in parallel.

However, it should be noted that the present invention is not limited to the use of pn junctions or FEOL capacitor structures as a tuneable capacitance. BEOL capacitor structures such as MIM capacitors can be used as well.

While an individual capacitor of this type may not be tuneable, a tuneability can still be achieved for such types of capacitors by using a set of parallel capacitors, which can be individually activated or deactivated, depending on the matrix input signal $V_d$. The matrix input signal $V_d$ in these cases is suitably a digital signal vector, wherein each vector component is associated with one capacitor of the set of capacitors. The capacitors preferably have different capacitance values to achieve a higher resolution in the representation of matrix input values. A particular embodiment uses a C-DAC as the tuneable charge storage component. The C-DAC is preferably a binary C-DAC with capacitance values representing a sequence of different powers of 2. Here, the matrix input signal is preferably provided to the tuneable charge storage component in a binary form, i.e. as a bit string, each bit being used to control one of the capacitors of the C-DAC and to thus individually activate or deactivate it depending on the matrix input value. Other types of C-DACs may be used, with appropriate adaptations of the matrix input signal.

Fig. 1b is a simplified block diagram of the matrix memory component of Fig. 1a that shows only the relevant input and outputs explained in the context of Fig. 1a. This representation will be used in later drawings as a simplified graphical representation of the matrix memory component M.

Figs. 2a and 2b show a simplified circuit diagram of another embodiment of a matrix memory component M' and a schematic block representation of this matrix memory component. The matrix memory component M' resembles the matrix memory component M of Fig. 1 in many aspect. The following description therefore focusses on differences between the two embodiments.

The matrix memory component M' comprises between its vector input switch S1 and its charge storage component C1 a resistive element R1. The resistive element R1 is tuneable to assume a resistance value $R_a$ uniquely corresponding to an input vector signal $V_a$. The resistance value is thus determined from the input vector value. Furthermore, the matrix memory component M' receives a fixed input voltage $V_{IN}$. Thus, no DAC is required in the present embodiment for converting the input vector value into the analog domain.

The matrix memory component M' is charged with a charge amount $Q_{ad}$ that is determined by the following formula:

$$Q_{ad} = C_d \cdot V_{IN} \cdot \left( 1 - e^{-\frac{t_0}{R_a C_d}} \right)$$

Here, $t_0$ is a pre-set time span (charging time span) of application of the input voltage $V_{iN}$ in the vector load phase via the closed input vector switch S1, $R_a$ is the resistance of the tuneable resistor set in accordance with the input vector value, and $C_d$ is the capacitance of the tuneable charge storage component set in accordance with the input matrix value. Plotted as a function of the time during charging time span, i.e. for values of time between the onset of charging and the end of the charging time span when a time $t_0$ has elapsed, the charge amount $Q_{ad}$ that is stored on the charge storage component exhibits a nonlinear dependence with a saturation behavior towards larger charging times (depending on the values of $R_a$ and $C_d$). The time span $t_0$ is suitably selected in a design phase, a device initialization phase or a calibration phase so as to allow arriving at a charge amount that exhibits a technically resolvable unique correspondence with the input vector value (i.e., $V_a$') over a desired range of values of the product of $R_a$ and $C_d$. One approach to achieve this is a compensation of the described non-linearity of the above charging function by a suitable pre-distortion of the input voltage $V_{IN}$ as a function of time during the charging time span $t_0$. The pre-distortion is suitably selected so as to achieve a linearly increasing charge as a function of $R_a$ and $C_d$.

Fig. 2b is a simplified block diagram of the matrix memory component of Fig. 2a that shows only the relevant input and outputs explained in the context of Fig. 2a.

The following description refers in parallel to Figs. 3a and 3b. Fig. 3a is a simplified circuit diagram of a matrix component column MC of an embodiment of a storage component matrix of a programmable in-memory computing device. Fig. 3b is a timing diagram for vector input switches for controlling provision of the analog input vector signals for charging the respective charge storage components of the matrix component column of Fig. 3a;

The matrix component column MC comprises a number n of matrix memory components M1, M2,...Mn of the type described in the context of Figs. 1a and 1b. Switch control signals provided to the individual matrix memory components are labelled with the letter σ and two subscript indices: a first index corresponds to that used in Figs 1a and 1b, and the second index is an order number indicating the position of the respective matrix memory component within the matrix column MC. The matrix input signals $V_{d11}$, $V_{d12}$, ..., $V_{d1n}$ provided to the individual matrix memory components are labelled by $V_d$ as in Fig. 1, followed by two subscript indices indicating the position of the respective matrix value within the input matrix. The shown matrix component column is assumed to be the first of n columns, which accounts for the second index "1".

A vector input device VI is arranged on the input side of the matrix component column MC and provides to the matrix memory components of the matrix columns MC input vector signals $V_{a1}$, $V_{a2}$, ..., $V_{an}$ that uniquely correspond to respective input vector values $a_1, a_2, ..., a_n$ of an input vector $(a_1\ a_2\ ...\ a_n)$. The input vector is in the present embodiment provided to the vector input device VI in digital form. The vector input device has n digital-to-analog converters hereinafter V-DACs labelled VDAC1, VDAC2, ...VDACn. Each V-DAC converts one received vector input value into an analog input vector signal that uniquely corresponds to the respective received input vector value of the input vector $(a_1\ a_2...\ a_n)$. The vector input device VI provides the analog input vector signals $V_{a1}$, $V_{a2}$, ..., $V_{an}$ also to matrix memory components of other columns of the storage component matrix, which are not shown in Fig. 3a. Also not shown is a matrix input device that provides the matrix input signals to the individual matrix memory components.

As can be seen, the matrix memory components M1, M2, ..., Mn of the matrix component column MC are connected in parallel on their output side via a column output line CO. This set of parallel-connected matrix components is in turn commonly connected in series with a first electrode of a column summation charge storage component $C_\Sigma$, whose second electrode is connected to the reference potential.

The column summation charge storage component $C_\Sigma$ is configured to accumulate the respective charge amounts output from the charge storage components of the matrix memory components M1, M2,...,Mn so as to generate a column summation output voltage $V_\Sigma$. The accumulation in the summation phase results in a charge amount on the column summation charge storage component $C_\Sigma$ that equals half the total sum of charge amounts that been loaded onto the tuneable charge storage components in the vector load phase. The summation output voltage measurable across the column summation charge storage component $C_\Sigma$ for a given matrix component column with n matrix memory elements is given by

$$V_\Sigma = \frac{1}{2} \cdot \frac{\sum_{i=1}^{n} Q_i}{C_\Sigma}$$

Since each charge Qi corresponds to a specific product of a respective input vector value and a respective input matrix value of the given matrix column, the summation output voltage is indicative of an output vector element formed by the sum of these products. It is noted that the column summation charge storage component $C_\Sigma$ can be implemented as a tuneable capacitor in order to provide for a scaling factor or an option to tune a gain in the column summation output voltage $V_\Sigma$. In another variant, the column summation charge storage component $C_\Sigma$ is implemented as a capacitance matrix of a downstream analog-to-digital converter or of an SAR ADC (successive approximation registers analog-to-digital converter).

The following turns to the function of the matrix component column MC. For the basic functionality of the individual matrix memory components, reference is made to the description of the matrix memory component M shown in Figs. 1a and b. Based on that description and on the explanation in the preceding paragraph, since the charge amounts output from the matrix memory components M1, M2,...Mn represent individual component products of input vector values and input matrix values, the column summation output voltage $V_\Sigma$ resulting from the charge accumulation in the column summation charge storage component $C_\Sigma$ is indicative of a sum of the component products determined in the individual matrix memory components M1, M2,...Mn. The column summation charge and thus, due to the capacitance value of the summation charge storage component, the output voltage $V_\Sigma$ thus represents an output vector value of an output vector resulting from the multiplication of the input vector with the input matrix. In the same way, each further matrix column contributes a further output vector value. To provide a corresponding output, a column read device (not shown) determines the set of column summation output voltages $V_\Sigma$ of the column summation charge storage components $C_\Sigma$ and provides a matrix product output signal indicative of the set of the column summation output voltages.

Also shown (and provided in each matrix component column) is a column reset switch $S_\Sigma$, which is connected in parallel to the column summation charge storage component $C_\Sigma$ for discharging the summation charge storage component via its connection to the reference potential in its closed state.

The following description turns to the control of the switches S1 to S3 of the individual matrix memory components and of the column reset switch $S_\Sigma$ during operation of the matrix component column MC to perform one vector-matrix multiplication. It is assumed that the storage component matrix has been loaded with an input matrix, so that each matrix memory component has its tuneable charge storage component tuned to a capacitance value that uniquely corresponds to a respective input matrix value. The process of determining of the vector-matrix product is divided into four phases, labelled Phase1 to Phase 4 in the following switching table.

| Phase | Description | S1 | S2 | S3 | $S_\Sigma$ |
|---|---|---|---|---|---|
| 1 | loading the matrix with input vector values | Closed | Open | Open | Open |
| 2 | generating column summation output voltages | Open | Closed | Open | Open |
| 3 | reading column summation output voltages | Open | Open | Open | Open |
| 4 | reset | Open | Open | Closed | Closed |

During Phase 1, the vector load phase, closing the vector input switches S1 of the individual matrix memory components ensures that the charge storage components are loaded with a charge amount corresponding to the individual product of input matrix value and input vector value. The timing diagram shown in Fig. 3b is a schematic representation of the timing of the individual control signals $\sigma_{11}$ to $\sigma_{1n}$ which are respectively provided to the switches S1 of the different matrix memory components M1 to Mn during Phase 1. As can be seen, all charge storage components are loaded at the same time (in parallel) for a common charge time span $t_0$. This process is performed in parallel in all columns.

After ending Phase 1, a respective column output voltage is generated in each of the matrix component columns by transferring and accumulating the charges from the different matrix memory components on the column summation charge storage component $C_\Sigma$ during Phase 2, the summation phase. To this end, the component product accumulation switches S2 are closed while the vector input switches S1 are now open.

After the accumulation has been performed, the component product accumulation switches S2 are open again, and the respective voltage generated by the individual charged column summation charge storage components $C_\Sigma$ in

all n matrix component columns is measured to determine output vector values of the output vector. In this Phase 3, the measurement phase, all switches S1 to S3 and $S_\Sigma$ are thus open.

Finally, to prepare for the next multiplication operation, a reset of the different capacitors is performed by discharging them to the reference potential in Phase 4, the reset phase. To this end, the switches S3 and $S_\Sigma$ are closed, and the switches S1 and S2 are kept open. The operation can then jump back to Phase 1 in order to perform the next vector-matrix multiplication.

In a variant, Phase 4 is performed two parts: a first part of Phase 4 is used to reset the tuneable charge storage components of the individual matrix memory components via the reset switches S3. In a second part of Phase 4, the column summation charge storage components $C_\Sigma$ in all n matrix component columns are reset. This variant is further developed in another variant, which overlaps the second part of Phase 4 with Phase 1 of the next vector-matrix multiplication. This way, a time saving of at least one clock cycle can be achieved. This variant can be used in particular, if no significant memory effects occur after each operation even without resetting.

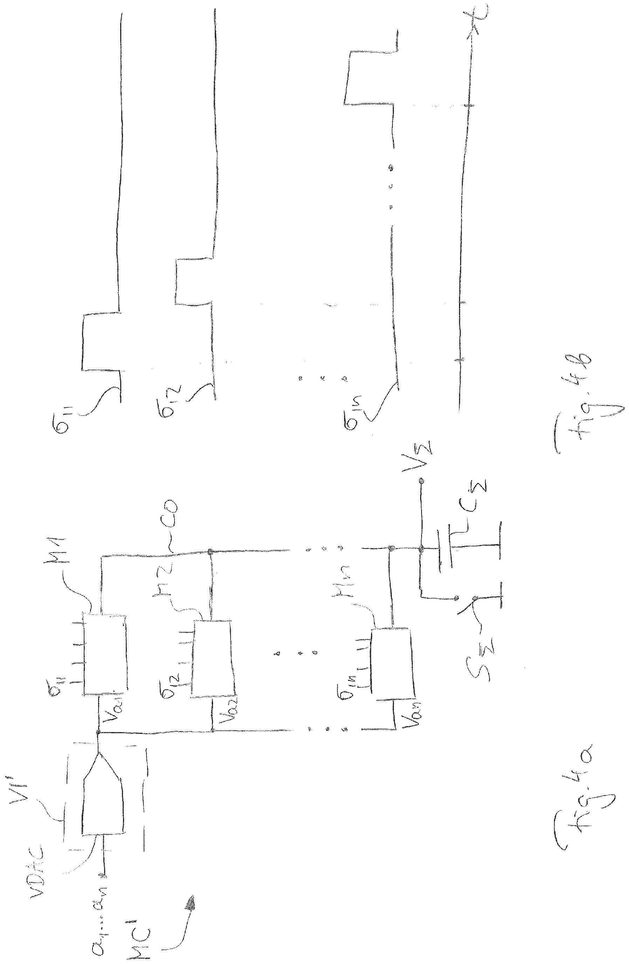

The following description turns to Figs. 4a and 4b. Fig. 4a is a simplified circuit diagram of a matrix component column of a further embodiment of a storage component matrix of a programmable in-memory computing device. Fig. 4b is a timing diagram for vector input switches for controlling provision of the analog input vector signals for charging the respective charge storage components of the matrix column of Fig. 4a;

The embodiment shown in Fig. 4a largely resembles that of Fig. 3a. For that reason, the following description will only turn to differences. Otherwise, reference is made to the description of Fig. 3a.

The embodiments of Fig. 4a and 3a differ in the structure of the vector input device. In Fig. 4a, only one digital-to-analog converter VDAC is used for loading the matrix component column with the input vector values. This goes along with a modification of the timing of the control of the vector input switches S1, which is performed by a matrix switch phase controller (not shown). The timing diagram shown in Fig. 4b is a schematic representation of the timing of the individual control signals $\sigma_{11}$ to $\sigma_{1n}$ which are respectively provided to the switches S1 of the different matrix memory components M1 to Mn during Phase 1. As can be seen, the individual charge storage components are loaded one after the other (in series), each for a common charge time span to. This serial process is performed in parallel in all columns, so that the storage component matrix is loaded row by row.

Since VDACs assume a significant part of chip area and power dissipation the serialization, i.e., time multiplexing of the provision of the vector input values, allows reducing the hardware expenditure to a single V-DAC. As described this V-DAC charges all capacitances of the matrix component column one after the other. This also represents a significant advantage over the RRAM solution mentioned in the beginning of this specification, since the capacitor holds the charge after charging and no current is required or flowing during the entire operation of the V-DAC.

In summary, the present invention is directed to a programmable in-memory computing device and corresponding method for performing multiplication of an input vector with an input matrix. For performing in-memory multiplication of an input vector with an input matrix a storage component matrix comprises matrix memory components with a charge storage component that is tuneable by a respective matrix input signal to assume a capacitance value uniquely corresponding to an input matrix value. A vector input switch controls provision of the analog input vector signal for charging the charge storage component of the matrix memory component to a charge amount representing a mathematical product of the respective input vector value and the respective input matrix value. The matrix memory components of a column are arranged in parallel connection with each other and commonly connected in series connection with a column summation charge storage component which accumulates the charge amounts output from the charge storage components to generate a column summation output voltage indicative of a sum of the component products.

## Claims

1. A programmable in-memory computing device for performing multiplication of an input vector of input vector values with an input matrix having input matrix columns of input matrix values, the device having:

   - a storage component arrangement, hereinafter storage component matrix, comprising

      - matrix memory components that are arranged and connected to represent matrix component rows and matrix component columns of the storage component matrix;
      - a matrix input device for providing to the matrix memory components respective matrix input signals uniquely corresponding to input matrix values of an input matrix;
      - a vector input device for providing to the matrix memory components input vector signals uniquely corresponding to respective input vector values of the input vector; and wherein

   - each matrix memory component comprises

- a tuneable charge storage component that is connected between the vector input device on its input side and a reference potential and that is tuneable by the respective matrix input signal to assume a capacitance value uniquely corresponding to the respective input matrix value; and

- a vector input switch for controlling provision of the respective analog input vector signal for charging the charge storage component of the matrix memory component to a charge amount representing a mathematical product of the respective input vector value and the respective input matrix value;

- and wherein

- the matrix memory components of a given matrix component column are each followed by a component product accumulation switch for controlling an output of the charge amount from the respective matrix memory component, and are arranged in a parallel connection with each other and commonly connected in a series connection with a respective column summation charge storage component that is configured to accumulate the respective charge amounts output from the charge storage components so as to generate a column summation output voltage that is indicative of a sum of the component products.

2. The device of claim 1, further comprising

- a column read device for determining a set of column summation output voltages of the column summation charge storage components and for providing a matrix product output signal indicative of the set of the column summation output voltages;

- for each matrix component column a column reset switch, which is connected in parallel to its column summation charge storage component to discharge the summation charge storage component via its connection to the reference potential in its closed state.

3. The device of claim 2, further comprising

- a matrix switch phase controller, which is configured to control the vector input switches, the component product accumulation switches, the component reset switches and the column reset switches of the computation matrix to operate the device in one of a respective number of switching phases at a given time, the switching phases comprising:

- a vector load phase, in which the vector input switches are switched to allow applying the input vector signals for charging the charge storage components;

- a summation phase after the vector load state, in which the component product accumulation switches are switched to allow transferring respective charge amounts from the charge storage components for accumulation in the summation charge storage component;

- a measurement phase after the summation phase, in which the charge of the summation charge storage component of each storage component column is measured; and a reset phase, in which the summation charge storage components of the matrix component columns are discharged.

4. The device of claim 3, wherein

- each matrix memory component comprises a respective component reset switch, which is connected in parallel to its charge storage component to discharge the charge storage component via its connection to the reference potential in its closed state; and

- the matrix switch phase controller is configured to additionally control discharging of the charge storage components of the matrix memory component in the reset state.

5. The device of any of the preceding claims, wherein

- the vector input device is configured to provide to each matrix memory component a digital voltage signal indicative of the respective input vector value;

- each matrix memory component has a digital-to-analog converter, hereinafter V-DAC, which is configured to receive the respective digital voltage signal and to provide the respective input vector signal in the form of an analog voltage signal; and

- the matrix switch phase controller is configured to control switching states of the vector input switches of the individual matrix memory components in parallel.

6. The device of any of the claims 1 to 4, wherein

- the vector input device is configured to provide to each matrix memory component a digital voltage signal or a digital voltage signal vector indicative of the respective input vector value;
- the vector input device comprises one V-DAC for each column of matrix memory components and is configured to receive the respective digital voltage signals and to provide to the V-DACs the input vector signals for the respective column as a time sequence; and
- the matrix switch phase controller is configured to control switching states of the vector input switches of the individual matrix memory components in correspondence with the time sequence.

7. The device of any of the preceding claims, wherein

- the matrix switch phase controller is configured to control the vector input switch of each matrix memory component to allow the charging of the charge storage component of the respective matrix memory component for a common fixed amount of time, and wherein
- the vector input device is configured to provide the vector input signal in the form of an analog voltage signal having a voltage amount uniquely corresponding to the respective input vector value.

8. The device of any of the claims 2 to 6, wherein

- the matrix switch phase controller is configured to control the vector input switch of each matrix memory component in the vector load state to allow the charging of the charge storage component of the matrix memory component for a an amount of time that uniquely corresponds to the input vector value; and wherein
- the vector input device is configured to provide the vector input signal in the form of an analog voltage signal having a fixed voltage amount.

9. The device of any of the claims 2 to 6, wherein

- each matrix memory component comprises between its vector input switch and its charge storage component a resistive element that is tuneable to assume a resistance value uniquely corresponding to a given input vector value;
- the matrix switch phase controller is configured to control the vector input switch of each matrix memory component in the vector load state to allow the charging of the charge storage component of the matrix memory component for a common fixed amount of time, and to tune the resistive element to assume a resistance value uniquely corresponding to the current input vector value;
- the vector input device is configured to provide, via the vector input switch, an input voltage having a fixed voltage amount.

10. The device of any of the preceding claims, wherein

- the tuneable charge storage component comprises a p-n junction of a semiconductor component; and wherein
- the matrix input device is configured to provide the vector input signal in the form of a voltage signal that controls the thickness of a depletion layer formed at the p-n junction of the semiconductor component.

11. The device of any of the preceding claims, wherein

- the tuneable charge storage component comprises a MIS layer structure of a semiconductor component, in particular of a MOS transistor; and wherein
- the vector input device is configured to provide the vector input signal in the form of a voltage signal that controls a capacitance of the MIS layer structure of the semiconductor component.

12. The device of any of the preceding claims, wherein

- the tuneable charge storage component is a C-DAC having a plurality of capacitors arranged in parallel, in particular a binary C-DAC wherein each capacitor has a capacitance value corresponding to a power of 2; and wherein
- the matrix input signal is a signal vector that controls activation or deactivation of the capacitances of the tuneable charge storage component in correspondence with the respective input matrix value.

13. A method for performing multiplication of an input vector of input vector values with an input matrix having input matrix columns of input matrix values, the method comprising:

- providing a programmable in-memory computing device according to one of the preceding claims;
- providing to the device an input matrix having input matrix columns of input matrix values, and an input vector of input vector values;
- charging the charge storage components of the matrix memory component to respective charge amounts, each representing a mathematical product of a respective input vector value and a respective input matrix value;
- column-wise accumulating the respective charge amounts output from the charge storage components so as to generate column summation output voltages indicative of a respective sum of the component products in a given column of the matrix;
- determining a set of the column summation output voltages as the product of the input vector with the input matrix.

Fig. 1b

Fig. 2b

Fig. 1a

Fig. 2a

Fig. 3b

Fig. 3a

Fig. 4a

Fig. 4b

Europäisches
Patentamt
European
Patent Office
Office européen
des brevets

# EUROPEAN SEARCH REPORT

Application Number

EP 22 15 0589

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 580 473 B2 (HEWLETT PACKARD ENTPR DEV LP [US]) 3 March 2020 (2020-03-03) * columns 2-10; figures 1,4 * | 1-4,7,8, 13 | INV. G11C7/10 G06F7/523 |
| Y | | 5,6 | G06F7/53 |
| A | | 9-12 | G06N3/063 |
| | ----- | | |
| Y | US 2021/397937 A1 (KESKIN MUSTAFA [US] ET AL) 23 December 2021 (2021-12-23) * paragraphs [0025] - [0047]; figures 1A-12 * | 5,6 | |
| | ----- | | |

TECHNICAL FIELDS SEARCHED (IPC)

G11C
G06F
G06N

The present search report has been drawn up for all claims

| Place of search | Date of completion of the search | Examiner |
|---|---|---|
| The Hague | 24 June 2022 | Czarik, Damien |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 15 0589

This annex lists the patent family members relating to the patent documents cited in the above-mentioned European search report.
The members are as contained in the European Patent Office EDP file on
The European Patent Office is in no way liable for these particulars which are merely given for the purpose of information.

24-06-2022

| Patent document cited in search report | | Publication date | Patent family member(s) | | Publication date |
|---|---|---|---|---|---|
| US 10580473 | B2 | 03-03-2020 | JP | 6311076 B2 | 11-04-2018 |
| | | | JP | 2017535836 A | 30-11-2017 |
| | | | KR | 20170076676 A | 04-07-2017 |
| | | | US | 2017323677 A1 | 09-11-2017 |
| | | | US | 2019189180 A1 | 20-06-2019 |
| | | | WO | 2016068886 A1 | 06-05-2016 |
| US 2021397937 | A1 | 23-12-2021 | TW | 202209328 A | 01-03-2022 |
| | | | US | 2021397937 A1 | 23-12-2021 |
| | | | WO | 2021262736 A1 | 30-12-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **AMIRALI AMIRSOLEIMANI et al.** *Adv. Intell. Syst.,* 2020, vol. 2, 2000115